# EUROPEAN PATENT SPECIFICATION

(11) **EP 0 517 337 B1**
(45) Date of publication and mention of the grant of the patent: **08.09.1999**
(21) Application number: 92201624.1
(22) Date of filing: 04.06.1992
(51) Int. Cl.: C08G 59/06, C08G 61/02, H05K 1/03

(54) **Epoxy resin composition for electrical laminates**
Epoxydharzzusammensetzung für elektrische Schichtstoffe
Compositions de résines époxydes et leur utilisation dans les stratifiées électriques

(30) Priority: 07.06.1991 JP 16232091
(43) Date of publication of application: 09.12.1992
(73) Proprietor: SHELL INTERNATIONALE RESEARCH MAATSCHAPPIJ B.V., 2596 HR Den Haag (NL)
(72) Inventor: Imura, Tetsuroh, c/o Yuka Shell Epoxy KK, Minato-ku, Tokyo 106 (JP); Ohta, Masayuki, c/o Yuka Shell Epoxy KK, Minato-ku, Tokyo 106 (JP); Fukuzawa, Takao, c/o Yuka Shell Epoxy KK, Minato-ku, Tokyo 106 (JP)

(56) References cited:
- DE-A- 1 595 633
- FR-A- 1 325 208
- US-A- 3 378 525

## Description

The present invention relates to epoxy resin compositions for use in electrical laminates which, upon curing, absorb only a small amount of water and exhibit good solder heat resistance even after water absorption. These epoxy resin compositions are suitable for the production of copper-clad epoxy resin laminates for printed circuit boards.

Epoxy resins are used in the production of electrical laminates because of their good electrical insulation, heat resistance, chemical resistance, mechanical resistance and processability.

The recent tendency toward smaller and lighter electric machines and equipment requires printed circuit boards having more components on the same area as before. One way to meet this requirement is to make the printed circuits board in layers, to make finer wiring patterns, to reduce the thickness of the board, and to change the method of mounting components on the board. Therefore, printed circuit boards are produced and components are mounted under more severe conditions than before.

In the case of epoxy resins, however, there is problem caused by water absorption, which deteriorates the insulating properties and solder heat resistance of the laminate.

To cope with this situation, a laminate has been proposed comprising an epoxy resin obtained by condensation of a diglycidyl ether of bisphenol A and tetrabromobisphenol A. This epoxy resin, however, does not satisfactorily meet the above-mentioned requirements in respect of water absorption and solder heat resistance after water absorption.

Therefore it is an object of the present invention to provide an epoxy resin composition for use in the production of electrical laminates (particularly copperclad epoxy resin laminates for printed circuit boards) which provides a cured product with low water absorption and which exhibits good solder heat resistance even after water absorption.

To address the above-mentioned problem, the present inventors carried out a series of researches, which led to the finding that the object of the present invention is achieved by employing a specific epoxy resin.

The present invention provides an epoxy resin composition for use in electrical laminates comprising an epoxy resin, a hardener, and a solvent, characterized in that said epoxy resin is at least one kind of cyclic terpene skeleton-containing epoxy resin selected from the group consisting of (1) an epoxy resin being a reaction product of said cyclic terpene skeleton-containing epoxy resin which is produced by reacting a cyclic terpene skeleton-containing epoxy resin produced by reacting a phenolic compound with a cyclic terpene compound to give a cyclic terpene skeleton-containing polyhydric phenolic compound, which is subsequently reacted with an epihalohydrin, and a polyhydric phenolic compound, and (2) an epoxy resin being a reaction product of said cyclic terpene skeleton-containing epoxy resin (1), another epoxy resin, and a polyhydric phenolic compound, characterized in that as sole hardener a polyhydric phenol is used.

The epoxy resin composition of the present invention contains a cyclic terpene skeleton-containing epoxy resin which is produced from a cyclic terpene skeleton-containing polyhydric phenolic compound and an epihalohydrin. A starting material for the cyclic terpene skeleton-containing polyhydric phenolic compound is a monocyclic or bicyclic terpene compound. Examples of the cyclic terpene compounds include:

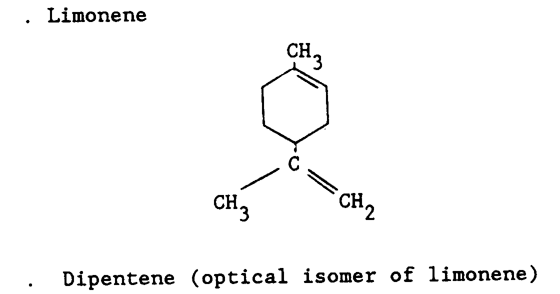

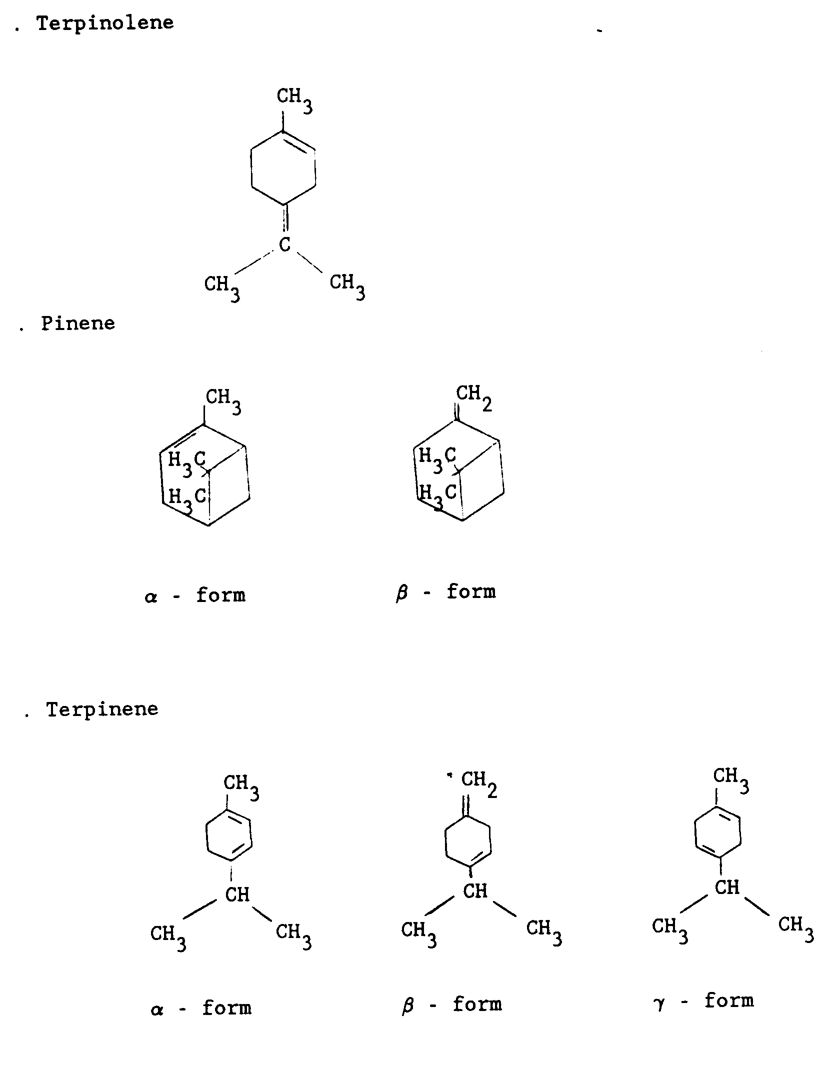

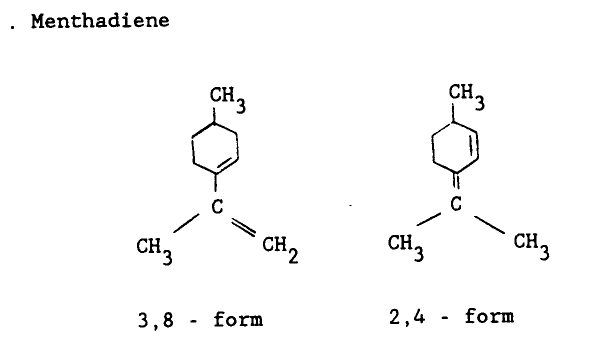

The preferred cyclic terpene is limonene. The other starting material for preparing the cyclic terpene skeleton-containing polyhydric phenolic compound is a phenolic compound such as for example phenol, cresol, xylenol, propylphenol, nonylphenol, hydroquinone, resorcinol, methoxyphenol, bromophenol, bisphenol A and bisphenol F.

The addition reaction between said cyclic terpene compound and said phenolic compound may be carried out by reacting 1 mole of cyclic terpene compound with of from 1 to 12, preferably with of from 2 to 8 and most preferably with 2 moles of the phenolic compound. Preferably the reaction is carried out at 40-160 °C for 1-10 hours in the presence of an acid catalyst.

Examples of the acid catalyst include hydrochloric acid, sulfuric acid, phosphoric acid, polyphosphoric acid, boron trifluoride or a complex thereof, and activated white clay.

The reaction may be carried out in the absence of a solvent; but is normally carried out in a solvent such as for example the aromatic hydrocarbons, alcohols, and ethers.

The cyclic terpene skeleton-containing polyhydric phenolic compound thus produced varies in structure depending on the starting materials. The one derived from limonene and phenol is a compound represented by structural formula (I) below, whereas the one derived from α-terpinene and phenol is a compound represented by structural formula (II) below.

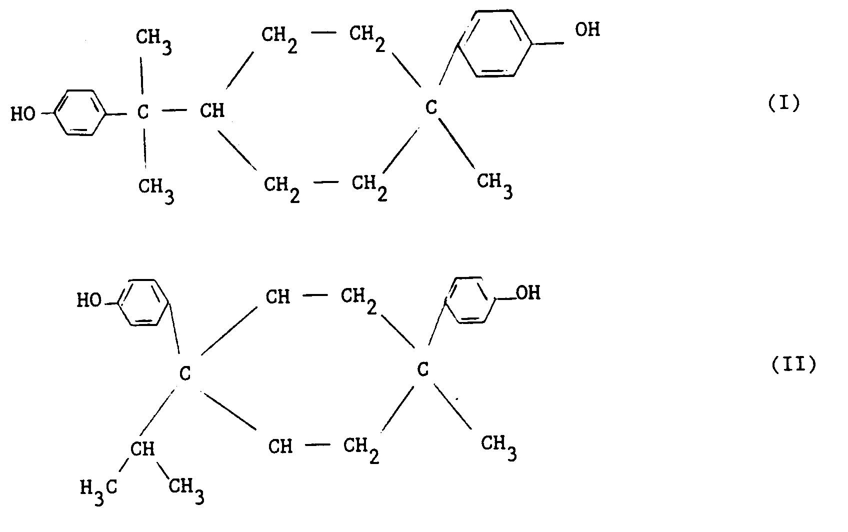

The cyclic terpene skeleton-containing polyhydric phenolic compound is subsequently reacted with an epihalohydrin to give the cyclic terpene skeleton-containing epoxy resin which is a major element in the present invention. This process is preferably carried out in the following manner. First, the polyhydric phenolic compound is uniformly dissolved in of from 2 to 20 moles epihalohydrin per mole of phenolic hydroxyl group. The solution thus obtained is then mixed by stirring with of from 1 to 2 moles of alkali metal hydroxide, in the form of solid or aqueous solution, per mole of phenolic hydroxyl group. This reaction may be carried out at 60-105 °C under normal pressure or at 50-80 °C under reduced pressure. During this reaction, water is removed from the reaction system by azeotropic distillation. The condensed azeotrope is separated into water and organic fraction, and the latter is returned to the reaction system. Preferably the alkali metal hydroxide is added little by little either intermittently or continuously over a period of time of from 1-8 hours in order to avoid abrupt reactions. The total reaction time is preferably 1-10 hours.

After completion of the reaction, the reaction mixture is filtered or washed with water to remove insoluble salts (by-products) and unreacted epihalohydrin is removed by distillation under reduced pressure.

The desired cyclic terpene skeleton-containing epoxy resin is thus obtained.

The epihalohydrin used in this reaction is usually epichlorohydrin or epibromohydrin. The alkali metal hydroxide used in this reaction is usually NaOH or KOH.

The reaction may be catalyzed by quaternary ammonium salts, such as tetramethylammonium chloride and tetraethylammonium bromide; tertiary amines, such as benzyldimethylamine and 2,4,6-(tris-dimethylaminomethyl)phenol; imidazoles, such as 2-ethyl-4-methylimidazole and 2-phenylimidazole; phosphonium salts such as ethyltriphenylphosphonium iodide; and phosphines such as triphenylphosphine.

Further an inert organic solvent may be used in this reaction including alcohols, such as ethanol and isopropanol; ketones, such as acetone and methyl ethyl ketone; ethers, such as dioxane and ethylene glycol dimethyl ether; and aprotic polar solvents, such as dimethylsulfoxide and dimethylformamide).

The cyclic terpene skeleton-containing epoxy resin is further reacted with a polyhydric phenolic compound or with a polyhydric phenolic compound and another epoxy resin. Mixtures of the just mentioned cyclic terpene skeleton-containing epoxy resins may also be used.

The polyhydric phenolic compound for this purpose is not specifically limited; but a preferred one is tetrabromobisphenol A providing flame retardancy to the cyclic terpene skeleton-containing epoxy resin. The "Another epoxy resin" mentioned above may be any kind of epoxy resin.

The epoxy resin composition of the present invention may contain the thus obtained cyclic terpene skeleton-containing epoxy resin as a major component, preferably more than 50 wt% and a small amount of other epoxy resins as a minor component. Examples of "other epoxy resins" include glycidyl ether epoxy resins, glycidyl ester epoxy resins, glycidyl amine epoxy resins, linear aliphatic epoxy resins, alicyclic epoxy resins, heterocyclic epoxy resins, and halogenated epoxy resins and other polyfunctional epoxy resins. The glycidyl ether epoxy resins are obtained by reacting a phenol and an epihalohydrin, said phenol including bisphenol A, bisphenol F, resorcinol, hydroquinone, methyl resorcinol, phenol novolak, cresol novolak, resorcinol novolak, bisphenol A novolak and polyhydric phenols which are obtained by the condensation reaction of a phenol with an aldehyde such as hydroxybenzaldehyde, crotonaldehyde, and glyoxal.

The epoxy resin composition of the present invention further comprises a hardener and solvent as essential components. Optionally additives such as cure accelerators and flame retardants may be added.

The sole hardener are polyhydric phenols. Examples of polyhydric phenol hardeners include phenol novolak resins, cresol novolak resins, tetrabromobisphenol A, novolak resins obtained by a condensation reaction of bisphenol A and formaldehyde, polyhydric phenols obtained by a condensation reaction of a phenol, such as phenol and alkyl-substituted phenol, and an aldehyde, such as hydroxybenzaldehyde, crotonaldehyde, glyoxal, and other aliphatic and aromatic aldehydes, polyhydric phenols obtained by addition reaction of a diene, such as dicyclopentadiene and a phenol in the presence of an acid catalyst, cyclic terpene skeleton-containing polyhydric phenols by adding a phenol to a cyclic terpene compound (the same one as used in the production of the above-mentioned epoxy resin), and cyclic terpene skeleton-containing novolak resins obtained by condensation reaction of the cyclic terpene skeleton-containing polyhydric phenol compound and an aldehyde. Of these hardeners, tetrabromobisphenol A is preferably used because it gives rise to a cured product which is superior in flame retardancy. Cyclic terpene skeleton-containing polyhydric phenol compounds and novolak resins thereof are also preferred because they give rise to a cured product having superior water resistance. Combinations of the above hardeners may also be used.

Examples of the cure accelerator are amines, such as benzylmethylamine and imidazole compounds and tertiary phosphines, such as triphenylphosphine. These cure accelerators may be used together with the above-mentioned hardeners, if desired.

Examples of solvents which may be used include acetone, methyl ethyl ketone, toluene, xylene, methyl isobutyl ketone, ethyl acetate, ethylene glycol monomethyl ether, N,N-dimethylformamide, N,N-dimethylacetamide, methanol, and ethanol or mixtures thereof.

The epoxy resin composition of the present invention may also comprise additives including fillers and flame retardants. A preferred flame retardant is a reactive flame retardant such as tetrabromobisphenol A.

The epoxy resin composition of the present invention may be used in the preparation of copper-clad epoxy resin laminates in the usual way. A typical process consists of impregnating a glass cloth with the epoxy resin composition, heating and drying the glass cloth to prepare a prepreg, placing a copper foil on one side or both sides of a single prepreg or a pile of prepregs, and heating the assembly under pressure to form a laminate.

### EXAMPLES

The invention will be described in more detail with reference to the following Examples and Comparative Examples, in which quantities are expressed as parts by weight.

### Example A (Synthesis of polyhydric phenol)

A reactor equipped with a thermometer, stirrer, and condenser was filled with 3384 g of phenol and 34 g of boron trifluoridediethyl ether complex. At a temperature of 70-80 °C, 816 g limonene was added dropwise over 3 hours. The reactants were stirred at that temperature for 2 hours to carry out reaction. The reaction mixture was washed three times with 1000 cc of water. Unreacted phenol and by-products were distilled away by heating under reduced pressure. Finally, the reactor was kept at 160 °C and 5 mmHg for 1 hour. Thus 1520 g of cyclic terpene skeleton-containing phenolic compound was obtained. Analysis by liquid chromatography indicated that this compound contains the polyhydric compound as much as 89%. This compound is designated as "polyhydric phenol A" hereinafter.

### Example B (Synthesis of polyhydric phenol)

In the same reactor as used in Example A was filled with 1092 g of "polyhydric phenol A", 1000 g of toluene, and 5 g of oxalic acid. The reactants were heated to 80 °C for uniform dissolution. 75 g of 36% aqueous solution of formaldehyde was added to the solution over 1 hour, while keeping the inside of the reactor at 80 °C. The temperature was kept at 80 °C for 1 hour to carry out reaction.

After the completion of reaction, the reaction mixture was heated to distill away water and toluene. Finally, the reaction mixture was kept at 160 °C and 5 mmHg for 1 hour to remove water and toluene completely. A cyclic terpene skeleton-containing polyhydric phenol compound in polymer form was thus obtained, which is a yellowish solid having a softening point of 126 °C. This compound is designated as "polyhydric phenol B" hereinafter.

### Example A (Synthesis of epoxy resin)

A reactor equipped with a thermometer, stirrer, and condenser was filled with 162 g of polyhydric phenol A, 740 g of epichlorohydrin, and 1.1 g of tetraethylammonium chloride. The reactor was heated at 117 °C in an oil bath to carry out reaction under reflux for 2 hours. After cooling to 60 °C, the reactor was provided with a water separator. 42 g of NaOH was added to the reaction mixture, and reaction was carried out at 50-70 °C under reduced pressure (40-100 mmHg). During the reaction, water formed in the reaction and epichlorohydrin were removed by azeotropic distillation. The reaction was suspended when a theoretical amount of water was distilled away (about 2 hours later).

The thus obtained epichlorohydrin solution of epoxy resin was diluted with 2.5 liters of methyl isobutyl ketone, and the diluted solution was washed with a large amount of water to remove sodium chloride formed by the reaction and excess sodium hydroxide. The washed solution was neutralized with a 3% aqueous solution of phosphoric acid. The neutralized solution was freed of epichlorohydrin and methyl isobutyl ketone under reduced pressure (100-0.1 mmHg, 60-150 °C) using a rotary evaporator. Thus 196 g of epoxy resin was obtained. This epoxy resin has an epoxy equivalent of 233 g/eq and is designated as "Epoxy resin A" hereinafter.

### Example B (Synthesis of epoxy resin)

A reactor equipped with a thermometer and stirrer was filled with 66 g of epoxy resin A, 34 g of tetrabromobisphenol A, and 0.03 g of catalyst (2-ethyl-4-methylimidazole). After reaction at 150 °C for 180 minutes a cyclic terpene skeleton-containing epoxy resin was obtained having an epoxy equivalent of 647 g/eq. This epoxy resin is designated as "Epoxy resin B" hereinafter.

### Example C (Synthesis of epoxy resin)

A reactor equipped with a thermometer and stirrer was filled with 46 g of epoxy resin A, 20 g of Epikote 180S70 (a product of Yuka-Shell Epoxy Co., Ltd., o-cresolnovolak epoxy resin, having an epoxy equivalent of 209 g/eq. and a softening point of 74 °C), 34 g of tetrabromobisphenol A, and 0.03 g of catalyst (2-ethyl-4-methylimidazole). After reaction at 150 °C for 180 minutes, a cyclic terpene skeleton-containing epoxy resin was obtained having an epoxy equivalent of 615 g/eq. This epoxy resin is designated as "Epoxy resin C" hereinafter.

### Example D (Synthesis of epoxy resin)

A reactor equipped with a thermometer and stirrer was filled with 46 g of epoxy resin A, 34 g of tetrabromobisphenol A, and 0.024 g of catalyst (2-ethyl-4-methylimidazole). After reaction at 150 °C for 180 minutes, a cyclic terpene skeleton-containing epoxy resin was obtained having an epoxy equivalent of 1135 g/eq. This epoxy resin is designated as "Epoxy resin D" hereinafter.

### Examples 1 to 13 and Comparative Examples 1 to 5

Epoxy resin varnishes were prepared according to the formulations shown in Table 1. The epoxy resins used in the formulations are as follows:
. Epoxy resins A to D obtained in Examples A to D for synthesis of epoxy resin.
. Epikote 5046 (a product of Yuka-Shell Epoxy Co., Ltd., slightly brominated bisphenol A epoxy resin, having an epoxy equivalent of 469 g/eq. and containing 21.0 wt% bromine).
. Epikote 5048 (a product of Yuka-Shell Epoxy Co., Ltd., slightly brominated bisphenol A epoxy resin, having an epoxy equivalent of 675 g/eq. and containing 25.0 wt% bromine).
. Epikote 180S70 (a product of Yuka-Shell Epoxy Co., Ltd., o-cresolnovolak epoxy resin, having an epoxy equivalent of 209 g/eq. and softening point of 74 °C).
. Epikote 5050 (a product of Yuka-Shell Epoxy Co., Ltd., highly brominated bisphenol A epoxy resin, having an epoxy equivalent of 395 g/eq. and containing 49.0 wt% bromine).
The hardeners used in the formulations are as follows:
. Tetrabromobisphenol A.
. Dicyandiamide.
. Phenol novolak resin.
. Polyhydric phenol B obtained in Example B for synthesis of polyhydric phenol.
The cure accelerator used in the formulations is 2-ethyl-4-methylimidazole.
The solvents used in the formulations are methyl ethyl ketone and ethylene glycol monomethyl ether.

A glass cloth was impregnated with each varnish thus obtained, and the impregnated glass cloth was dried at 130 °C for 5 minutes to give a prepreg containing 45 wt% epoxy resin composition (as nonvolatile matter). Eight sheets of the prepreg were placed on top of the other, and they were held between two sheets of copper foil (0.33 µm thick). The assembly was pressed at 170 °C and 40 kg/cm² for 1 hour. Thus a 1.6 mm thick copper-clad glass-epoxy resin laminate was obtained. The laminate has the characteristic properties as shown in Table 1.

The characteristic properties were measured and evaluated in the following manner.
(1) Glass transition point:
   Obtained from the chart of thermomechanical analysis (TMA), with temperature rising at a rate of 3 °C/minute.
(2) Peel strength of copper foil:
   Measured according to JIS C-6481.
(3) Water absorption:
   Measured according to JIS C-6481. A sample, with its copper foils removed by etching, is cut into a test piece, 50±1 mm wide and 50±1 mm long, and the test piece is treated in a pressure cooker at 120 °C and 2 atm for 4 hours to effect water absorption.
(4) Solder heat resistance after water absorption:
   Evaluated according to JIS C-6481. A test piece which has been treated in a pressure cooker at 120 °C and 2 atm for 4 hours is immersed in solder at 260 °C for 20 seconds. The copper foil surface and laminate surface are visually checked for blister and peeling. The solder heat resistance is rated as good (no blistering and peeling), fair (slight blistering and peeling), and poor (noticeable blistering and peeling).

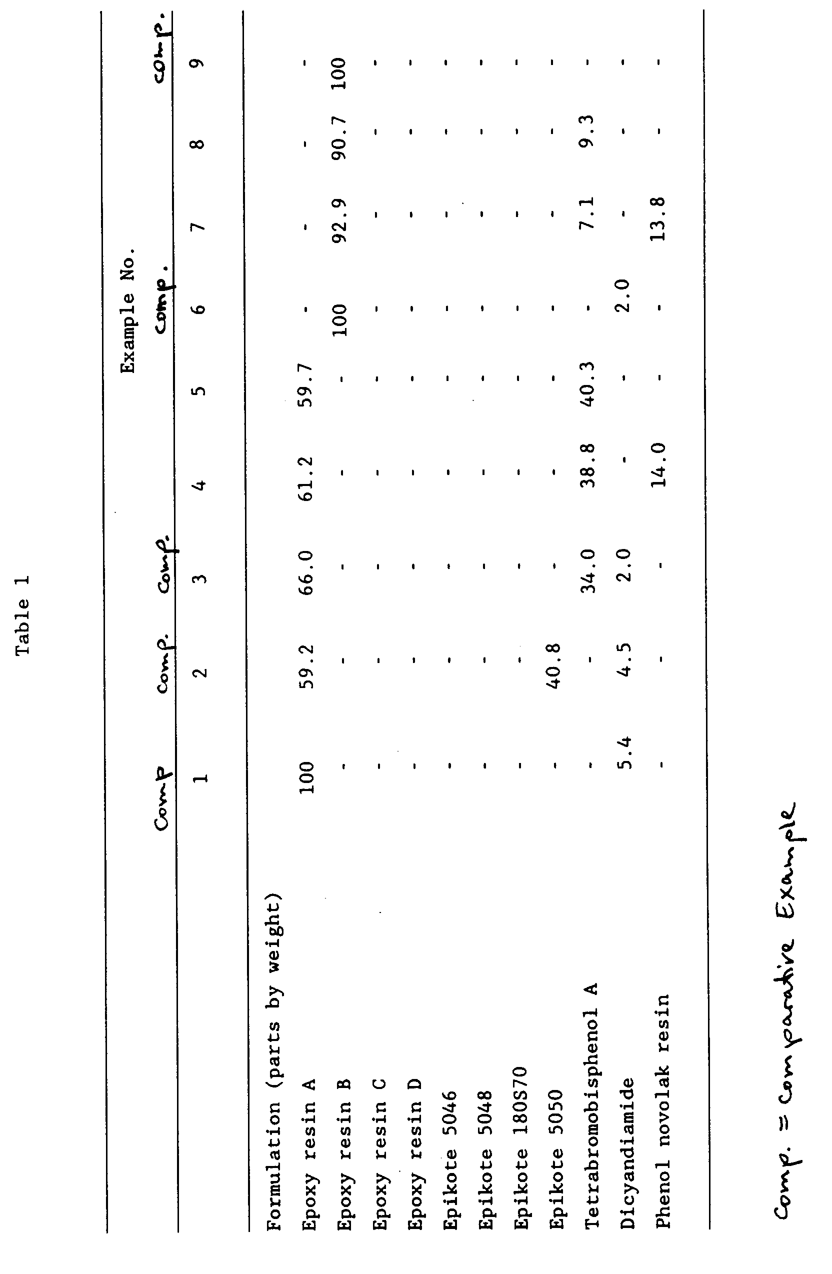

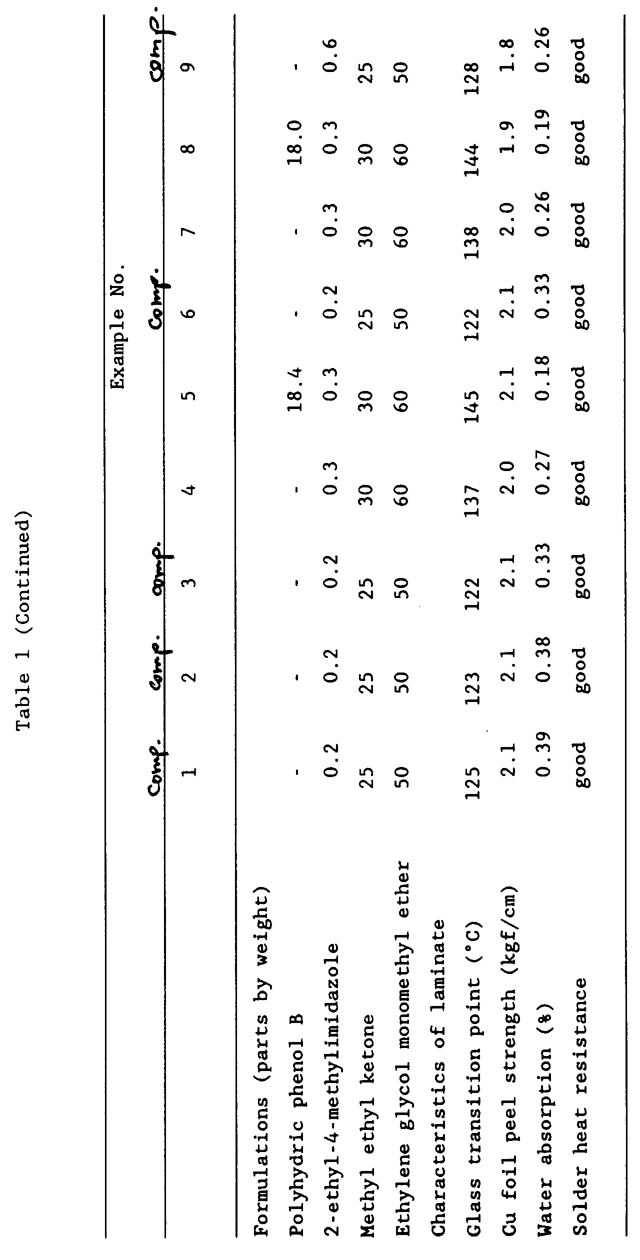

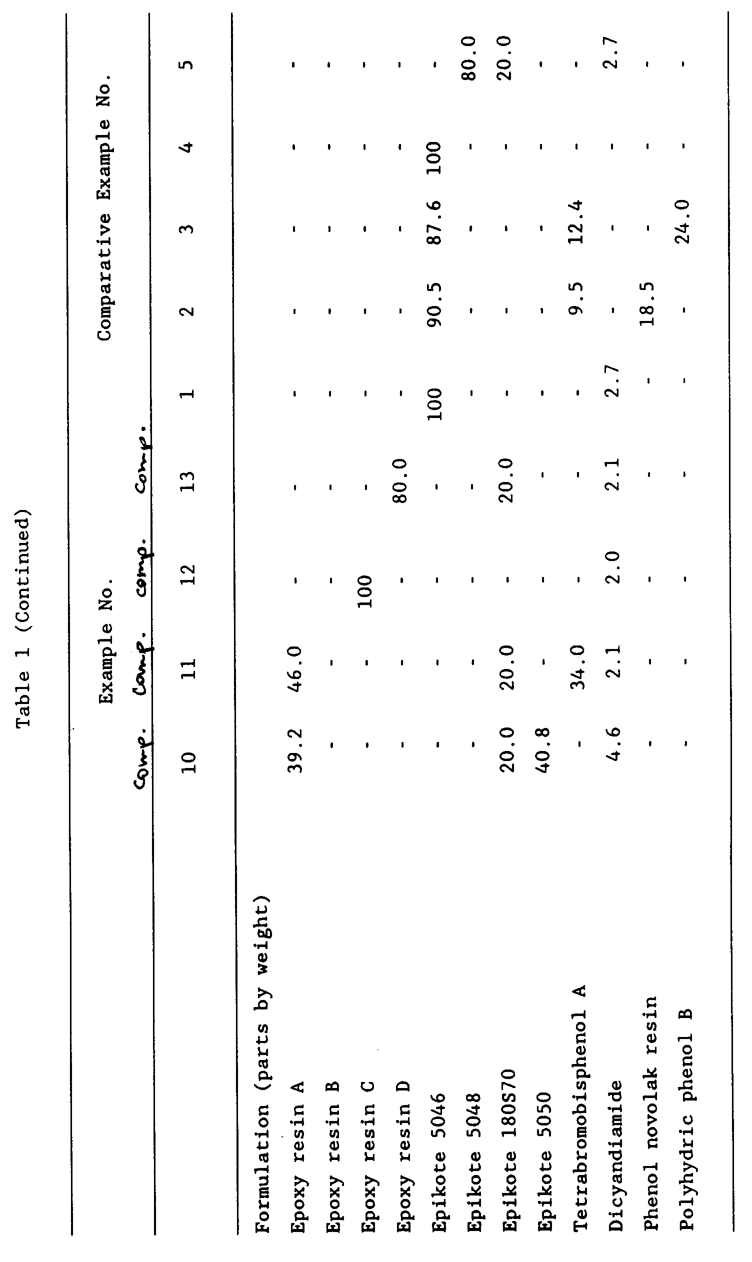

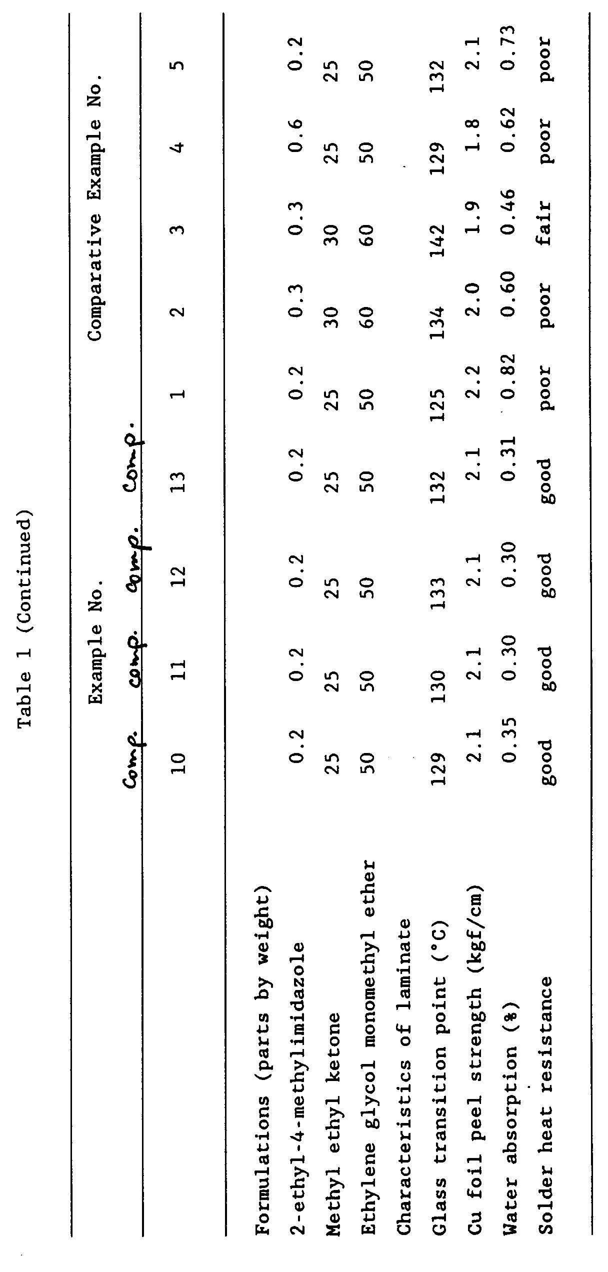

From the examples it can be concluded that the epoxy resin composition of the present invention yields a cured product which absorbs only a small amount of water and exhibits outstanding solder heat resistance even after water absorption. Therefore, it can be advantageously used for the production of copper-clad epoxy resin laminates for printed circuit boards.

## Claims (Claims for the following Contracting State(s): BE, CH, LI, DE, FR, GB, IT, NL)

1. An epoxy resin composition for use in electrical laminates comprising an epoxy resin, a hardener, and a solvent, characterized in that said epoxy resin is at least one kind of cyclic terpene skeleton-containing epoxy resin which is selected from the group consisting of (1) an epoxy resin being a reaction product of a cyclic terpene skeleton-containing epoxy resin produced by reacting a phenolic compound with a cyclic terpene compound to give a cyclic terpene skeleton-containing polyhydric phenolic compound, which is subsequently reacted with an epihalohydrin, and a polyhydric phenolic compound, and (2) an epoxy resin being a reaction product of said cyclic terpene skeleton-containing epoxy resin (1), another epoxy resin, and a polyhydric phenolic compound, and that as sole hardener a polyhydric phenol is used.

2. An epoxy resin composition as claimed in claim 1, wherein the cyclic terpene compound used in the preparation of (1) is selected from the group consisting of limonene, dipentene, terpinolene, pinene, terpinene and menthadiene.

3. An epoxy resin composition as claimed in claim 2, wherein the cyclic terpene compound is limonene.

4. An epoxy resin composition as claimed in any one of the claims 1 to 3, wherein the phenolic compound used in the preparation of said cyclic terpene skeleton containing epoxy resin is selected from the group consisting of phenol, cresol, xylenol, propylphenol, nonylphenol, hydroquinone, resorcinol, methoxyphenol, bromophenol, bisphenol A and bisphenol F.

5. An epoxy resin composition as claimed in claim 4, wherein the phenolic compound is phenol.

6. An epoxy resin composition as claimed in claims 1-5, wherein the hardener is a phenol novolak resin or a cyclic terpene skeleton containing polyhydric phenolic compound or tetrabromobisphenol A.

7. An epoxy resin composition as claimed in any one of the claims 1 to 6, wherein the polyhydric phenolic compound used in the preparation of (1) or (2) is tetrabromobisphenol A.

8. Electrical laminates, obtainable from an epoxy resin composition according to claims 1-7.

## Claims (Claims for the following Contracting State(s): ES)

1. Process for the preparation of an epoxy resin composition for use in electrical laminates comprising an epoxy resin, a hardener, and a solvent, characterized in that said epoxy resin is at least one kind of cyclic terpene skeleton-containing epoxy resin which is selected from the group consisting of (1) an epoxy resin being a reaction product of a cyclic terpene skeleton-containing epoxy resin produced by reacting a phenolic compound with a cyclic terpene compound to give a cyclic terpene skeleton-containing polyhydric phenolic compound, which is subsequently reacted with an epihalohydrin, and a polyhydric phenolic compound, and (2) an epoxy resin being a reaction product of said cyclic terpene skeleton-containing epoxy resin (1), another epoxy resin, and a polyhydric phenolic compound, and that as sole hardener a polyhydric phenol is used.

2. Process as claimed in claim 1, wherein the cyclic terpene compound used in the preparation of (1) is selected from the group consisting of limonene, dipentene, terpinolene, pinene, terpinene and menthadiene.

3. Process as claimed in claim 2, wherein the cyclic terpene compound is limonene.

4. Process as claimed in any one of the claims 1 to 3, wherein the phenolic compound used in the preparation of said cyclic terpene skeleton containing epoxy resin is selected from the group consisting of phenol, cresol, xylenol, propylphenol, nonylphenol, hydroquinone, resorcinol, methoxyphenol, bromophenol, bisphenol A and bisphenol F.

5. Process as claimed in claim 4, wherein the phenolic compound is phenol.

6. Process as claimed in claims 1-5, wherein the hardener is a phenol novolak resin or a cyclic terpene skeleton containing polyhydric phenolic compound or tetrabromobisphenol A.

7. Process as claimed in any one of the claims 1 to 6, wherein the polyhydric phenolic compound used in the preparation of (1) or (2) is tetrabromobisphenol A.

8. Process for manufacture electrical laminates, by using an epoxy resin composition obtainable according to claims 1-7.

## Patentansprüche (Patentansprüche für folgende(n) Vertragsstaat(en): BE, CH, LI, DE, FR, GB, IT, NL)

1. Epoxyharzzusammensetzung zur Anwendung in elektrischen Laminaten mit einem Gehalt an einem Epoxyharz, einem Härter und einem Lösungsmittel, dadurch gekennzeichnet, daß das Epoxyharz wenigstens eine Art von cyclischem terpenskeletthältigem Epoxyharz ist, ausgewählt aus der Gruppe, die aus (1) einem Epoxyharz, das ein Reaktionsprodukt eines cyclischen terpenskeletthältigen Epoxyharzes mit einer mehrwertigen Phenolverbindung ist, welches Epoxyharz durch Umsetzen einer Phenolverbindung mit einer cyclischen Terpenverbindung zur Ausbildung einer cyclischen terpenskeletthältigen mehrwertigen Phenolverbindung, die anschließend mit einem Epihalogenhydrin umgesetzt wird, hergestellt wird, und aus (2) einem Epoxyharz besteht, das ein Reaktionsprodukt des cyclischen terpenskeletthältigen Epoxyharzes (1), eines weiteren Epoxyharzes und einer mehrwertigen Phenolverbindung ist, und daß als einziges Härtungsmittel ein mehrwertiges Phenol verwendet wird.

2. Epoxyharzzusammensetzung nach Anspruch 1, worin die in der Herstellung von (1) verwendete cyclische terpenhältige Phenolverbindung aus der aus Limonen, Dipenten, Terpinolen, Pinen, Terpinen und Menthadien bestehenden Gruppe ausgewählt ist.

3. Epoxyharzzusammensetzung nach Anspruch 2, worin die cyclische Terpenverbindung Limonen ist.

4. Epoxyharzzusammensetzung nach einem der Ansprüche 1 bis 3, worin die in der Herstellung des cyclischen terpenskeletthältigen Epoxyharzes verwendete Phenolverbindung aus der aus Phenol, Cresol, Xylenol, Propylphenol, Nonylphenol, Hydrochinon, Resorcin, Methoxyphenol, Bromphenol, Bisphenol A und Bisphenol F bestehenden Grupe ausgewählt ist.

5. Epoxyharzzusammensetzung nach Anspruch 4, worin die Phenolverbindung Phenol ist.

6. Epoxyharzzusammensetzung nach den Ansprüchen 1 bis 5, worin der Härter ein Phenolnovolakharz oder eine cyclische terpenskeletthältige mehrwertige Phenolverbindung oder Tetrabrombisphenol A ist.

7. Epoxyharzzusammensetzung nach einen der Ansprüche 1 bis 6, worin die in der Herstellung von (1) oder (2) verwendete mehrwertige Phenolverbindung Tetrabrombisphenol A ist.

8. Elektrische Laminate, erhältlich aus einer Epoxyharzzusammensetzung nach den Ansprüchen 1 bis 7.

## Patentansprüche (Patentansprüche für folgende(n) Vertragsstaat(en): ES)

1. Verfahren zur Herstellung einer Epoxyharzzusammensetzung zur Anwendung in elektrischen Laminaten mit einem Gehalt an einem Epoxyharz, einem Härter und einem Lösungsmittel, dadurch gekennzeichnet, daß das Epoxyharz wenigstens eine Art von cyclischem terpenskeletthältigem Epoxyharz ist, ausgewählt aus der Gruppe, die aus (1) einem Epoxyharz, das ein Reaktionsprodukt eines cyclischen terpenskeletthältigen Epoxyharzes mit einer mehrwertigen Phenolverbindung ist, welches Epoxyharz durch Umsetzen einer Phenolverbindung mit einer cyclischen Terpenverbindung zur Ausbildung einer cyclischen terpenskeletthältigen mehrwertigen Phenolverbindung, die anschließend mit einem Epihalogenhydrin umgesetzt wird, hergestellt wird, und aus (2) einem Epoxyharz besteht, das ein Reaktionsprodukt des cyclischen terpenskeletthältigen Epoxyharzes (1), eines weiteren Epoxyharzes und einer mehrwertigen Phenolverbindung ist, und daß als einziges Härtungsmittel ein mehrwertiges Phenol verwendet wird.

2. Verfahren nach Anspruch 1, worin die in der Herstellung von (1) verwendete cyclische terpenhältige Phenolverbindung aus der aus Limonen, Dipenten, Terpinolen, Pinen, Terpinen und Menthadien bestehenden Gruppe ausgewählt ist.

3. Verfahren nach Anspruch 2, worin die cyclische Terpenverbindung Limonen ist.

4. Verfahren nach einem der Ansprüche 1 bis 3, worin die in der Herstellung des cyclischen terpenskeletthältigen Epoxyharzes verwendete Phenolverbindung aus der aus Phenol, Cresol, Xylenol, Propylphenol, Nonylphenol, Hydrochinon, Resorcin, Methoxyphenol, Bromphenol, Bisphenol A und Bisphenol F bestehenden Grupe ausgewählt ist.

5. Verfahren nach Anspruch 4, worin die Phenolverbindung Phenol ist.

6. Verfahren nach den Ansprüchen 1 bis 5, worin der Härter ein Phenolnovolakharz oder eine cyclische terpenskeletthältige mehrwertige Phenolverbindung oder Tetrabrombisphenol A ist.

7. Verfahren nach einen der Ansprüche 1 bis 6, worin die in der Herstellung (1) oder (2) verwendete mehrwertige Phenolverbindung Tetrabrombisphenol A ist.

8. Verfahren zur Herstellung von elektrischen Laminaten durch Anwendung einer nach den Ansprüchen 1 bis 7 erhältlichen Epoxyharzzusammensetzung.

## Revendications (Revendications pour l'(les) Etat(s) contractant(s) suivant(s): BE, CH, LI, DE, FR, GB, IT, NL)

1. Composition de résine époxy utilisable dans des stratifiés électriques comprenant une résine époxy, un durcisseur et un solvant, caractérisée en ce que ladite résine époxy est au moins un type de résine époxy contenant un squelette de terpène cyclique qui est choisie dans le groupe comprenant (1) une résine époxy constituée d'un produit réactionnel d'une résine époxy contenant un squelette de terpène cyclique produite par la réaction d'un composé phénolique avec un composé de terpène cyclique pour donner un composé phénolique polyatomique contenant un squelette de terpène cyclique, que l'on fait ensuite réagir avec une épihalohydrine, et d'un composé phénolique polyatomique, et (2) une résine époxy constituée par un produit réactionnel de la résine époxy contenant un squelette de terpène cyclique (1) susdite, d'une autre résine époxy et d'un composé phénolique polyatomique, et en ce qu'on utilise comme seul durcisseur un phénol polyatomique.

2. Composition de résine époxy suivant la revendication 1, dans laquelle le composé de terpène cyclique utilisé dans la préparation de (1) est choisi dans le groupe comprenant le limonène, le dipentène, le terpinolène, le pinène, le terpinène et le menthadiène.

3. Composition de résine époxy suivant la revendication 2, dans laquelle le composé de terpène cyclique est le limonène.

4. Composition de résine époxy suivant l'une quelconque des revendications 1 à 3, dans laquelle le composé phénolique utilisé dans la préparation de la résine époxy contenant un squelette de terpène cyclique est choisi dans le groupe comprenant le phénol, le crésol, le xylénol, le propylphénol, le nonylphénol, l'hydroquinone, le résorcinol, le méthoxyphénol, le bromophénol, le bisphénol A et le bisphénol F.

5. Composition de résine époxy suivant la revendication 4, dans laquelle le composé phénolique est le phénol.

6. Composition de résine époxy suivant l'une quelconque des revendications 1 à 5, dans laquelle le durcisseur est une résine phénol-novolaque ou un composé phénolique polyatomique contenant un squelette de terpène cyclique ou le tétrabromobisphénol A.

7. Composition de résine époxy suivant l'une quelconque des revendications 1 à 6, dans laquelle le composé phénolique polyatomiqué utilisé dans la préparation de (1) ou (2) est le tétrabromobisphénol A.

8. Stratifiés électriques, obtenables à partir d'une composition de résine époxy suivant l'une quelconque des revendications 1 à 7.

## Revendications (Revendications pour l'(les) Etat(s) contractant(s) suivant(s): ES)

1. Procédé de préparation d'une composition de résine époxy utilisable dans des stratifiés électriques comprenant une résine époxy, un durcisseur et un solvant, caractérisé en ce que ladite résine époxy est au moins un type de résine époxy contenant un squelette de terpène cyclique qui est choisie dans le groupe comprenant (1) une résine époxy constituée par un produit réactionnel d'une résine époxy contenant un squelette de terpène cyclique produite par la réaction d'un composé phénolique avec un composé de terpène cyclique pour donner un composé phénolique polyatomique contenant un squelette de terpène cyclique, que l'on fait réagir ensuite avec une épihalohydrine, et d'un composé phénolique polyatomique, et (2) une résine époxy constituée par un produit réactionnel de la résine époxy contenant un squelette de terpène cyclique (1) précitée, d'une autre résine époxy, et d'un composé phénolique polyatomique, et en ce qu'on utilise comme seul durcisseur un phénol polyatomique.

2. Procédé suivant la revendication 1, dans lequel le composé de terpène cyclique utilisé dans la préparation de (1) est choisi dans le groupe comprenant le limonène, le dipentène, le terpinolène, le pinène, le terpinène et le menthadiène.

3. Procédé suivant la revendication 2, dans lequel le composé de terpène phénolique est le limonène.

4. Procédé suivant l'une quelconque des revendications 1 à 3, dans lequel le composé phénolique utilisé dans la préparation de la résine époxy contenant un squelette de terpène cyclique est choisi dans le groupe comprenant le phénol, le crésol, le xylénol, le propylphénol, le nonylphénol, l'hydroquinone, le résorcinol, le méthoxyphénol, le bromophénol, le bisphénol A et le bisphénol F.

5. Procédé suivant la revendication 4, dans lequel le composé phénolique est le phénol.

6. Procédé suivant l'une quelconque des revendications 1 à 5, dans lequel le durcisseur est une résine phénol-novolaque ou un composé phénolique polyatomique contenant un squelette de terpène cyclique ou le tétrabromobisphénol A.

7. Procédé suivant l'une quelconque des revendications 1 à 6, dans lequel le composé phénolique polyatomiqué utilisé dans la préparation de (1) ou (2) est le tétrabromobisphénol A.

8. Procédé de fabrication de stratifiés électriques, en utilisant une composition de résine époxy obtenable suivant l'une quelconque des revendications 1 à 7.
